# FASCICULE DE BREVET EUROPEEN

(11) **EP 2 956 565 B1**
(45) Date de publication et mention de la délivrance du brevet: **17.10.2018**
(21) Numéro de dépôt: 14708612.8
(22) Date de dépôt: 04.02.2014
(51) Int. Cl.: C23C 10/20, C23C 10/02, C23C 10/60

(54) **PROCEDE DE DEPOT D'UN REVETEMENT CONTRE LA CORROSION A PARTIR D'UNE SUSPENSION**
VERFAHREN ZUR ABSCHEIDUNG EINER KORROSIONSSCHUTZBESCHICHTUNG AUS EINER SUSPENSION
METHOD FOR DEPOSITING A CORROSION-PROTECTION COATING FROM A SUSPENSION

(30) Priorité: 13.02.2013 FR 1351228
(43) Date de publication de la demande: 23.12.2015
(73) Titulaire: L'Air Liquide Société Anonyme pour l'Etude et l'Exploitation des Procédés Georges Claude, 75007 Paris (FR); Centre National de la Recherche Scientifique (C.N.R.S.), 75794 Paris Cedex 16 (FR); Université de Lorraine, 54052 Nancy Cedex (FR)
(72) Inventeur: RICHET, Nicolas, F-78330 Fontenay- Le- Fleury (FR); MAZET, Thierry, F-54000 Nancy (FR); VILASI, Michel, F-54136 Bouxieres aux Dames (FR); MATHIEU, Stéphane, F-54600 Villers les Nancy (FR)
(74) Mandataire: Laigneau, Amandine
(86) Numéro de dépôt international: PCT/FR2014/050194
(87) Numéro de publication internationale: WO 2014/125188

(56) Documents cités:
- EP-A1- 2 305 853
- EP-A1- 2 392 685
- EP-A2- 1 186 680
- EP-A2- 2 060 653
- EP-A2- 2 540 857
- US-A1- 2007 009 660

## Description

La présente invention est relative à la réalisation d'un revêtement protecteur contre la corrosion sur un substrat présentant des cavités.

Les techniques de réalisation de revêtements peuvent se classer en trois grandes familles:
- la projection thermique,
- le dépôt chimique en phase vapeur, et
- le dépôt physique en phase vapeur.

Les techniques de projection thermique comme la projection plasma ou flamme consiste à envoyer des particules fondues ou partiellement fondues, à grande vitesse, à la surface de la pièce à protéger. Le revêtement est construit par couches successives. Ces techniques ne sont utilisables que sur des surfaces ouvertes ou facilement accessibles.

Les techniques de dépôt en phase vapeur utilisent un précurseur gazeux du revêtement à réaliser. Ce précurseur peut être produit à proximité directe de la surface à revêtir (pack cémentation) ou être transporter via un gaz sur la surface à revêtir (out of pack, CVD à partir de bouteille ou mélange gazeux,...). Les principales difficultés rencontrées pour la pack cémentation sont liées au remplissage de pièces présentant une géométrie complexe ou de très petites dimensions (quelques mm) avec la poudre de cément (mélange précurseur du revêtement). Les principales limitations des techniques utilisant des précurseurs gazeux concernent l'appauvrissement rapide du mélange gazeux en espèces réactives entrainant des hétérogénéités de composition chimique et/ou d'épaisseur du revêtement. Il est très difficile d'obtenir un revêtement homogène sur de grandes surfaces ou dans des géométries complexes.

Les techniques de dépôt physique en phase vapeur consistent à faire évaporer le ou les éléments constitutifs du revêtement avant de les condenser à la surface de la pièce à revêtir. L'évaporation se fait en général en bombardant une cible avec un faisceau de forte énergie (électrons ou ions). La distance entre la cible et la surface à revêtir est un paramètre majeur pour l'homogénéité de l'épaisseur du dépôt. Ces techniques sont très difficilement utilisables sur des pièces de géométrie complexe ou sur des surfaces non accessibles.

L'intensification des procédés industriels conduit à utiliser les matériaux dans des conditions de plus en plus sévères et à réduire la taille des pièces mise en oeuvre.

Dans la plupart des cas, il est nécessaire de protéger les pièces de leur environnement avec un revêtement. Comme présenté dans les paragraphes précédents, les géométries complexes et les surfaces non accessibles posent des problèmes pour la réalisation de revêtements avec les techniques traditionnelles.

Il est donc nécessaire de développer de nouvelles techniques de dépôt ou d'adapter les techniques existantes aux nouvelles contraintes.

Le pack cémentation est un procédé très ancien pour réaliser un revêtement sur une pièce. Cette dernière est placée dans un lit de poudre de cément, qui est un mélange de produits capables de générer une atmosphère réactive à haute température. Ce cément doit être placé à proximité de la surface à revêtir pour produire un revêtement homogène en épaisseur et en composition chimique. Des revêtements sont classiquement réalisés sur des pièces présentant des cavités de quelques centimètres en remplissant la pièce avec la poudre de cément.

Cependant lorsque les cavités ont des tailles caractéristiques de l'ordre du millimètre, et des rapports d'aspect (ratio longueur / largeur) élevés, l'introduction du cément est beaucoup plus complexe. C'est pourquoi, les procédés à partir de poudre, de type pack cémentation sont généralement utilisés pour des pièces ne présentant pas ou peu de zone difficile d'accès.

Dès lors, un problème qui se pose est d'améliorer les procédés de dépôt de revêtement sur des surfaces difficiles d'accès, c'est-à-dire des surfaces présentant des cavités.

Une solution de la présente invention est un procédé de dépôt d'un revêtement sur un substrat présentant au moins une cavité, comprenant les étapes successives suivantes :
a) une étape de broyage d'une poudre d'un agent activant et d'une poudre du métal ou de l'alliage à déposer sur le substrat,
b) une étape de mélange des poudres broyées à l'étape a), et d'un liquide de manière à former une suspension ;
c) une étape de décapage de la partie du substrat à revêtir
d) une étape d'application de la suspension sur la partie du substrat à revêtir ;
e) une première étape de chauffage de l'ensemble substrat-suspension à une température comprise entre 150°C et 400°C et pendant une durée comprise entre 20 et 60 minutes de manière à éliminer au moins en partie le liquide ;
f) une deuxième étape de chauffage de l'ensemble substrat - suspension issu de l'étape e) à une température comprise entre 500°C et la température de fusion de l'élément le moins réfractaire du métal ou de l'alliage à déposer et pendant une durée comprise entre 1 et 10 heures de manière à faire réagir l'agent activant et le métal ou l'alliage à déposer ;
g) une étape d'élimination des résidus pulvérulents ; et
h) une étape de récupération d'un ensemble substrat-revêtement.

Selon une alternative le procédé selon l'invention est un procédé de dépôt d'un revêtement sur un substrat présentant au moins une cavité, comprenant les étapes successives suivantes :
a) une étape de broyage d'une poudre d'un flux de décapage et d'une poudre du métal ou de l'alliage à déposer sur le substrat,
b) une étape de mélange des poudres broyées à l'étape a), et d'un liquide de manière à former une suspension ;
c) une étape de décapage de la partie du substrat à revêtir ;
d) une étape d'application de la suspension sur la partie du substrat à revêtir ;
e) une première étape de chauffage de l'ensemble substrat-suspension à une température comprise entre 50°C et 300°C et pendant une durée comprise entre 30 min et 5 h de manière à éliminer au moins en partie le liquide ;
f) une deuxième étape de chauffage de l'ensemble substrat - suspension issu de l'étape e) à une température supérieure à la température de fusion du flux de décapage pendant une durée comprise entre 20 min et 6h de manière à faire réagir le flux de décapage et le métal ou l'alliage à déposer ;
g) une étape d'élimination des résidus de poudre du flux de décapage ; et
h) une étape de récupération d'un ensemble substrat-revêtement.

Un agent activant est un composé qui forme une espèce gazeuse avec le précurseur de l'élément à déposer. Cette espèce gazeuse va ensuite se déposer à la surface de la pièce à revêtir pour former le revêtement. Les agents activants peuvent être des fluorures ou des chlorures.

Selon le cas, les deux procédés selon l'invention peuvent présenter une ou plusieurs des caractéristiques suivantes :
- l'étape e) est réalisée sous une atmosphère renouvelée toutes les x minutes avec 1min ≤ x ≤ 20 min
- l'étape f) est réalisée sous atmosphère statique de gaz neutre; le gaz neutre étant par exemple de l'argon ;
- à l'étape b) au moins un composé organique est ajouté au mélange ;
- le composé organique est choisi parmi les liants, les lubrifiants et les dispersants ;
- ledit procédé comprend entre l'étape e) et l'étape f) une étape i) de chauffage de l'ensemble substrat - suspension issu de l'étape e) à une température comprise entre 400°C la température de fusion de l'élément le moins réfractaire du métal ou de l'alliage à déposer et pendant une durée comprise entre 1 et 10 heures de manière à éliminer ou dégrader les composés organiques ;
- l'étape i) est réalisée sous une atmosphère renouvelée toutes les x minutes avec 1min ≤ x ≤ 20 min.
- l'étape d) d'application est réalisée par immersion du substrat dans la suspension ; par injection de la suspension dans la cavité du substrat ; ou par application au pinceau de la suspension dans la cavité du substrat ;
- l'étape g) d'élimination des résidus est effectuée par vibration ou lavage par des solutions aqueuses ;
- ledit procédé comprend après l'étape h) une dernière étape de chauffage de l'ensemble substrat - revêtement à une température comprise entre 900 et 1200°C et pendant une durée comprise entre 1 et 5 heures ;
- le substrat présente des cavités de diamètre équivalent minium e_{cm} et l'étape a) de broyage est réalisée de manière à n'obtenir que des particules présentant un diamètre équivalent d tel que d ≤ e_{cm}/10 ;
- le revêtement de l'ensemble substrat - revêtement récupéré à l'étape h présente une épaisseur comprise entre 5µm et 200µm, préférentiellement entre 5 et 80µm, plus préférentiellement entre 20 et 60 µm ;

Le substrat est choisi parmi les échangeurs de chaleur métalliques.

La taille des particules de cément peut être mesurée par granulométrie laser ou tamisage afin de s'assurer qu'aucune particule ou agglomérat de particules de cément ne dépasse la taille requise.

Une étape de désagglomération peut être nécessaire afin de « casser » les agglomérats de particules élémentaires qui peuvent dépasser la taille requise.

Les tailles des particules sont classiquement dans la gamme 1µm à 1mm, préférentiellement 1µm à 100µm.

Le diamètre équivalent est défini comme le diamètre du cylindre ou du cercle qui s'inscrit dans la section la plus petite donnant accès à la surface à revêtir. En effet, cette dernière n'a pas nécessairement une forme standard.

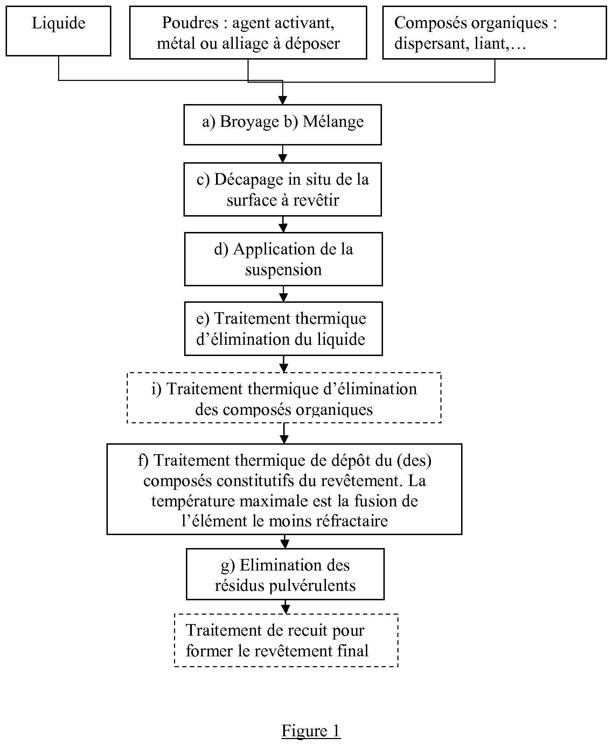

La Figure 1 schématise les différentes étapes du procédé selon l'invention.

La première étape (étape a) est une étape de broyage d'une poudre d'un agent activant et d'une poudre du métal ou de l'alliage à déposer sur le substrat. Cette étape de broyage permet d'obtenir une granulométrie adaptée à la pièce à revêtir. De préférence, que le substrat présente des cavités de diamètre équivalent minium e_{cm} et l'étape a) de broyage est réalisée de manière à n'obtenir que des particules présentant un diamètre équivalent d tel que d ≤ e_{cm}/10. Ces poudres doivent pouvoir être dispersées de manière homogène dans la phase liquide. La présence d'agglomérats peut entraîner un bouchage de l'entrée des cavités du substrat. La principale difficulté consiste à disperser des poudres de natures différentes au sein d'une même suspension de façon à obtenir une distribution homogène des éléments dans la suspension et un dépôt homogène.

La deuxième étape (étape b) est une étape de mélange des poudres broyées à l'étape a), et d'un liquide de manière à former une suspension. Des composés organiques de type liant ou lubrifiant peuvent être ajoutés dans la suspension, en particulier pour favoriser le mouillage sur la surface à revêtir et contrôler l'épaisseur déposée. Les caractéristiques de la suspension doivent également être adaptées à la technique d'application choisie.

La troisième étape (étape c) est une étape de décapage de la partie du substrat à revêtir. Sans décapage de la surface de la pièce à revêtir, aucun dépôt n'est possible. Le décapage permet une meilleure adhésion du revêtement sur le substrat et une meilleure homogénéité du dépôt car le précurseur se décompose à la surface de la pièce avec un effet catalytique de la surface. S'il y a des impuretés, le dépôt peut être altéré.

La quatrième étape (étape d) est une étape d'application de la suspension sur la partie du substrat à revêtir. L'application et en particulier l'application à l'intérieur des cavités du substrat peut être réalisée suivant plusieurs procédés : immersion du substrat dans la suspension ; injection de la suspension dans la cavité du substrat ; ou application au pinceau de la suspension dans la cavité du substrat. Des zones ne devant pas être recouvertes peuvent être protégées par un masque qui sera retiré avant ou pendant les étapes de chauffage. Après le dépôt de la suspension à la surface du substrat, l'excès peut être éliminé si nécessaire.

La cinquième étape (étape e) est une première étape de chauffage de l'ensemble substrat-suspension à une température comprise entre 50°C et 300°C et pendant une durée comprise entre 30 min et 5h de manière à éliminer au moins en partie le liquide. La température est fixée en fonction de la nature du liquide (exemples : éthanol, eau). Pour faciliter l'élimination du liquide un balayage de gaz peut être introduit à l'intérieur de la pièce afin de renouveler l'atmosphère. Lors de cette étape le point critique est de ne pas dégrader le dépôt.

L'étape suivante (étape i) est une étape intermédiaire puisqu'elle dépend de la présence ou non de composés organiques dans la suspension. Cette étape est une étape de chauffage de l'ensemble substrat - suspension issu de l'étape e) à une température comprise entre 400°C et la température de fusion de l'élément le moins réfractaire du métal ou de l'alliage à déposer et pendant une durée comprise entre 1 et 10 heures de manière à éliminer ou dégrader les composés organiques. On pourra comme pour l'élimination du liquide assurer un balayage gazeux pour renouveler l'atmosphère et éliminer les produits de la dégradation des composés organiques.

La sixième étape (étape f) est une deuxième étape de chauffage de l'ensemble substrat - suspension issu de l'étape e) à une température comprise entre 500°C et la température de fusion de l'élément le moins réfractaire du métal ou de l'alliage à déposer (par exemple 660°C pour l'aluminium) et pendant une durée comprise entre 1 et 10 heures de manière à faire réagir l'agent activant et le métal ou l'alliage à déposer. Ce traitement sera de préférence réalisé en atmosphère statique afin d'éviter un appauvrissement rapide de l'atmosphère en élément formateur du revêtement (Aluminium). Pour cela, le ou les cavités pourront être bouchées. Dans ce dernier cas, il faudra porter une attention particulière à l'augmentation de pression dans la pièce. On pourra également placer la cavité ouverte dans un lit de poudre de cément pour que ce dernier sature l'atmosphère de précurseur du ou des éléments à déposer.

Les étapes e) et i) pourront être réalisées simultanément ou successivement dans le cas où l'écart de température entre la température de la dégradation des organiques (étape i) et la température de la réaction entre l'agent activant et le métal ou l'alliage à déposer (étape f) est suffisamment importante (écart de température compris entre 50-100°C). Dans le cas contraire, on préférera réaliser l'étape e) indépendamment des étapes i) et f) qui pourront être réalisés simultanément.

La septième étape (étape g) est une étape d'élimination des résidus pulvérulents. Plusieurs techniques peuvent être utilisées telles que le lavage par des solutions aqueuses, attaque chimique, érosion,...

La huitième étape (étape h) est une étape de récupération d'un ensemble substrat-revêtement.

Le procédé selon l'invention peut comprendre une dernière étape de chauffage de l'ensemble substrat - revêtement à une température comprise entre 900 et 1200°C et pendant une durée comprise entre 1 et 5 heures.

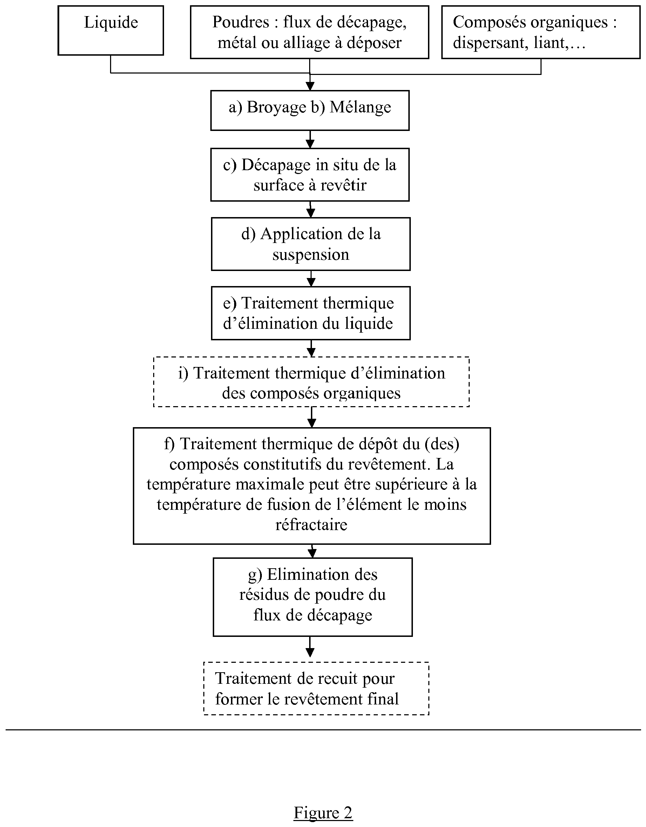

La Figure 2 schématise les différentes étapes du procédé alternatif.

Le procédé alternatif étant très similaire au procédé décrit précédemment, seules les étapes qui sont modifiées seront détaillées.

La première étape (étape a) est une étape de broyage d'une poudre d'un flux de décapage et d'une poudre du métal ou de l'alliage à déposer sur le substrat. De préférence le flux de décapage présente un point de fusion bas, c'est-à-dire ....Un exemple de flux de décapage est le K₃AlF₆-KAlF₄.

La sixième étape (étape f) est une deuxième étape de chauffage de l'ensemble substrat - suspension issu de l'étape e) à une température supérieure à la température de fusion du flux de décapage pendant une durée comprise entre 20 min et 6h de manière à faire réagir le flux de décapage et le métal ou l'alliage à déposer.

Ce procédé alternatif présente l'avantage de permettre un traitement thermique à plus haute température que le premier procédé limité par la température de fusion la plus basse des éléments à déposer. Ce degré de liberté peut-être intéressant pour l'élimination des composés organiques utilisés pour réaliser la suspension. En effet, une température de 600 à 800°C peut-être nécessaire dans certains cas pour dégrader totalement ces composés organiques.

## Revendications

1. Procédé de dépôt d'un revêtement sur un échangeur de chaleur métallique présentant au moins une cavité de diamètre équivalent mininum e_{cm}, comprenant les étapes successives suivantes :
a) une étape de broyage d'une poudre d'un agent activant et d'une poudre du métal ou de l'alliage à déposer sur l'échangeur,
b) une étape de mélange des poudres broyées à l'étape a), et d'un liquide de manière à former une suspension ;
c) une étape de décapage de la partie de l'échangeur à revêtir
d) une étape d'application de la suspension sur la partie de l'échangeur à revêtir ;
e) une première étape de chauffage de l'ensemble échangeur - suspension à une température comprise entre 150°C et 400°C et pendant une durée comprise entre 20 et 60 minutes de manière à éliminer au moins en partie le liquide ;
f) une deuxième étape de chauffage de l'ensemble échangeur - suspension issu de l'étape e) à une température comprise entre 500°C et la température de fusion de l'élément le moins réfractaire du métal ou de l'alliage à déposer et pendant une durée comprise entre 1 et 10 heures de manière à faire réagir l'agent activant et le métal ou l'alliage à déposer ;
g) une étape d'élimination des résidus pulvérulents ; et
h) une étape de récupération d'un ensemble échangeur - revêtement,
l'étape a) de broyage étant réalisée de manière à n'obtenir que des particules présentant un diamètre équivalent d tel que d ≤ e_{cm}/10.

2. Procédé de dépôt d'un revêtement sur un échangeur de chaleur métallique présentant au moins une cavité de diamètre équivalent miminum e_{cm}, comprenant les étapes successives suivantes :
a) une étape de broyage d'une poudre d'un flux de décapage et d'une poudre du métal ou de l'alliage à déposer sur l'échangeur,
b) une étape de mélange des poudres broyées à l'étape a), et d'un liquide de manière à former une suspension ;
c) une étape de décapage de la partie de l'échangeur à revêtir ;
d) une étape d'application de la suspension sur la partie de l'échangeur à revêtir ;
e) une première étape de chauffage de l'ensemble échangeur - suspension à une température comprise entre 50°C et 300°C et pendant une durée comprise entre 30 min et 5 h de manière à éliminer au moins en partie le liquide ;
f) une deuxième étape de chauffage de l'ensemble échangeur - suspension issu de l'étape e) à une température supérieure à la température de fusion du flux de décapage pendant une durée comprise entre 20 min et 6h de manière à faire réagir le flux de décapage et le métal ou l'alliage à déposer ;
g) une étape d'élimination des résidus de poudre du flux de décapage ; et
h) une étape de récupération d'un ensemble échangeur - revêtement,
l'étape a) de broyage étant réalisée de manière à n'obtenir que des particules présentant un diamètre équivalent d tel que d ≤ e_{cm}/10.

3. Procédé selon l'une des revendications 1 ou 2, **caractérisé en ce que** l'étape e) est réalisée sous une atmosphère renouvelée toutes les x minutes avec 1min ≤ x ≤ 20 min.

4. Procédé selon l'une des revendications 1 à 3, **caractérisé en ce que** l'étape f) est réalisée sous atmosphère statique de gaz neutre; le gaz neutre étant par exemple de l'argon.

5. Procédé selon l'une des revendications 1 à 4, **caractérisé en ce qu'**à l'étape b) au moins un composé organique est ajouté au mélange.

6. Procédé selon la revendication 5, **caractérisé en ce que** le composé organique est choisi parmi les liants, les lubrifiants et les dispersants.

7. Procédé selon l'une des revendications 5 ou 6, **caractérisé en ce que** ledit procédé comprend entre l'étape e) et l'étape f) une étape i) de chauffage de l'ensemble échangeur - suspension issu de l'étape e) à une température comprise entre 400°C la température de fusion de l'élément le moins réfractaire du métal ou de l'alliage à déposer et pendant une durée comprise entre 1 et 10 heures de manière à éliminer ou dégrader les composés organiques.

8. Procédé selon la revendication 7, **caractérisé en ce que** l'étape i) est réalisée sous une atmosphère renouvelée toutes les x minutes avec 1min ≤ x ≤ 20 min.

9. Procédé selon l'une des revendications 1 à 8, **caractérisé en ce que** l'étape d) d'application est réalisée :
- par immersion de l'échangeur dans la suspension ;
- par injection de la suspension dans la cavité de l'échangeur; ou
- par application au pinceau de la suspension dans la cavité de l'échangeur.

10. Procédé selon l'une des revendications 1 à 9, **caractérisé en ce que** l'étape g) d'élimination des résidus est effectuée par vibration ou lavage par des solutions aqueuses.

11. Procédé selon l'une des revendications 1 à 10, **caractérisé en ce que** ledit procédé comprend après l'étape h) une dernière étape de chauffage de l'ensemble échangeur - revêtement à une température comprise entre 900 et 1200°C et pendant une durée comprise entre 1 et 5 heures.

12. Procédé selon l'une des revendications 1 à 11, **caractérisé en ce que** le revêtement de l'ensemble échangeur - revêtement récupéré à l'étape h présente une épaisseur comprise entre 5µm et 200µm, préférentiellement entre 5 et 80µm, plus préférentiellement entre 20 et 60 µm.

## Patentansprüche

1. Verfahren zur Abscheidung einer Beschichtung auf einem Metallwärmetauscher mit mindestens einem Hohlraum mit äquivalentem Mindestdurchmesser e_{cm}, umfassend die folgenden aufeinanderfolgenden Schritte:
a) einen Schritt des Vermahlens eines Pulvers eines Aktivierungsmittels und eines Pulvers des Metalls oder der Legierung, das bzw. die auf dem Wärmetauscher abgeschieden werden soll,
b) einen Schritt des Mischens der gemahlenen Pulver in Schritt a) und einer Flüssigkeit, um eine Suspension zu bilden;
c) einen Schritt des Abbeizens des zu beschichtenden Teils des Wärmetauschers;
d) einen Schritt des Auftragens der Suspension auf den zu beschichtenden Teil des Wärmetauschers;
e) einen ersten Schritt der Erwärmung der Wärmetauscher-/Suspensionseinheit bei einer Temperatur zwischen 150°C und 400°C und für einen Zeitraum zwischen 20 und 60 Minuten, um die Flüssigkeit zumindest teilweise zu eliminieren;
f) einen zweiten Schritt der Erwärmung der aus Schritt e) hervorgegangenen Wärmetauscher-/Suspensionseinheit auf eine Temperatur zwischen 500°C und der Schmelztemperatur des am wenigsten feuerfesten Elements des abzuscheidenden Metalls oder der abzuscheidenden Legierung und für einen Zeitraum zwischen 1 und 10 Stunden, um das Aktivierungsmittel und das abzuscheidende Metall oder die abzuscheidende Legierung reagieren zu lassen;
g) einen Schritt der Beseitigung von Pulverrückständen; und
h) einen Schritt der Rückgewinnung einer Wärmetauscher-/Beschichtungseinheit,
wobei der Schritt des Vermahlens (a) derart ausgeführt wird, dass nur Partikel mit einem äquivalenten Durchmesser d erhalten werden, so dass d ≤ e_{cm}/10.

2. Verfahren zur Abscheidung einer Beschichtung auf einem Metallwärmetauscher mit mindestens einem Hohlraum mit äquivalentem Mindestdurchmesser e_{cm}, umfassend die folgenden aufeinanderfolgenden Schritte:
a) einen Schritt des Vermahlens eines Pulvers aus einem Beizflussmittel und eines Pulvers des Metalls oder der Legierung, das bzw. die auf dem Wärmetauscher abgeschieden werden soll,
b) einen Schritt des Mischens der gemahlenen Pulver in Schritt a) und einer Flüssigkeit, um eine Suspension zu bilden;
c) einen Schritt des Abbeizens des zu beschichtenden Teils des Wärmetauschers;
d) einen Schritt des Auftragens der Suspension auf den zu beschichtenden Teil des Wärmetauschers;
e) einen ersten Schritt der Erwärmung der Wärmetauscher-/Suspensionseinheit auf eine Temperatur zwischen 50°C und 300°C und für einen Zeitraum zwischen 30 Minuten und 5 Stunden, um die Flüssigkeit zumindest teilweise zu eliminieren;
f) einen zweiten Schritt der Erwärmung der aus Schritt c) hervorgegangenen Wärmetauscher-/Suspensionseinheit auf eine Temperatur über der Schmelztemperatur des Beizflussmittels für einen Zeitraum zwischen 20 Minuten und 6 Stunden, um das Beizflussmittel und das abzuscheidende Metall oder die abzuscheidende Legierung reagieren zu lassen;
g) einen Schritt der Beseitigung von Pulverrückständen aus dem Beizflussmittel; und
h) einen Schritt der Rückgewinnung einer Wärmetauscher-/Beschichtungseinheit, wobei der Schritt des Vermahlens a) derart ausgeführt wird, dass nur Partikel mit einem äquivalenten Durchmesser d erhalten werden, so dass d ≤ e_{cm}/10.

3. Verfahren nach einem der Ansprüche 1 oder 2, **dadurch gekennzeichnet, dass** Schritt e) in einer alle x Minuten mit 1min ≤ x ≤ 20 min erneuerten Atmosphäre durchgeführt wird.

4. Verfahren nach einem der Ansprüche 1 bis 3, **dadurch gekennzeichnet, dass** Schritt f) unter einer statischen neutralen Gasatmosphäre durchgeführt wird, wobei das neutrale Gas beispielsweise Argon ist.

5. Verfahren nach einem der Ansprüche 1 bis 4, **dadurch gekennzeichnet, dass** in Schritt b) dem Gemisch mindestens eine organische Verbindung zugesetzt wird.

6. Verfahren nach Anspruch 5, **dadurch gekennzeichnet, dass** die organische Verbindung aus Bindemitteln, Schmiermitteln und Dispergiermitteln ausgewählt wird.

7. Verfahren nach einem der Ansprüche 5 oder 6, **dadurch gekennzeichnet, dass** das Verfahren zwischen Schritt e) und Schritt f) einen Schritt i) der Erwärmung der aus Schritt e) hervorgegangenen Wärmetauscher-/Suspensionseinheit auf eine Temperatur im Bereich von 400°C der Schmelztemperatur des am wenigsten feuerfesten Elements des abzuscheidenden Metalls oder der abzuscheidenden Legierung und für einen Zeitraum zwischen 1 und 10 Stunden umfasst, um die organischen Verbindungen zu eliminieren oder abzubauen.

8. Verfahren nach Anspruch 7, **dadurch gekennzeichnet, dass** Schritt i) in einer alle x Minuten mit 1min ≤ x ≤ 20 min erneuerten Atmosphäre ausgeführt wird.

9. Verfahren nach einem der Ansprüche 1 bis 8, **dadurch gekennzeichnet, dass** der Schritt d) des Auftragens ausgeführt wird :
- durch Eintauchen des Wärmetauschers in die Suspension;
- durch Einspritzen der Suspension in den Wärmetauscherhohlraum; oder
- durch Pinselauftrag der Suspension im Wärmetauscherhohlraum.

10. Verfahren nach einem der Ansprüche 1 bis 9, **dadurch gekennzeichnet, dass** Schritt g) der Beseitigung von Rückständen durch Vibration oder Waschen mit wässrigen Lösungen durchgeführt wird.

11. Verfahren nach einem der Ansprüche 1 bis 10, **dadurch gekennzeichnet, dass** das Verfahren nach Schritt h) einen letzten Schritt der Erwärmung der Wärmetauscher-/Beschichtungseinheit auf eine Temperatur zwischen 900 und 1200°C und für einen Zeitraum zwischen 1 und 5 Stunden umfasst.

12. Verfahren nach einem der Ansprüche 1 bis 11, **dadurch gekennzeichnet, dass** die in Schritt h) gewonnene Beschichtung der Wärmetauscher-/Beschichtungseinheit eine Dicke zwischen 5µm und 200µm, vorzugsweise zwischen 5 und 80µm, mehr bevorzugt zwischen 20 und 60µm aufweist.

## Claims

1. A method for depositing a coating on a metal heat exchanger having at least one cavity with a minimum equivalent diameter e_{cm}, comprising the following successive steps:
a) a step of grinding a powder of an activating agent and a powder of the metal or alloy to be deposited on the exchanger,
b) a step of mixing the powders ground at step a), and a liquid, so as to form a suspension;
c) a step of pickling the part of the exchanger to be coated;
d) a step of applying the suspension to the part of the exchanger to be coated;
e) a first step of heating the exchanger/suspension assembly at a temperature of between 150 °C and 400 °C and for a period of between 20 and 60 minutes so as to at least partly eliminate the liquid;
f) a second step of heating the exchanger/suspension assembly resulting from step e) at a temperature of between 500 °C and the melting temperature of the least refractory elements of the metal or alloy to be deposited and for a period of between 1 and 10 hours so as to cause the activating agent and the metal or alloy to be deposited to react;
g) a step of elimination of the powdery residues; and
h) a step of recovering an exchanger/cladding assembly,
the grinding step a) being carried out so as to obtain only particles having an equivalent diameter d such that d ≤ e_{cm}/10.

2. A method for depositing a coating on a metal heat exchanger having at least one cavity with a minimum equivalent diameter e_{cm}, comprising the following successive steps:
a) a step of grinding a powder of a pickling flux and a powder of the metal or alloy to be deposited on the exchanger;
b) a step of mixing the powders ground at step a), and a liquid, so as to form a suspension;
c) a step of pickling the part of the exchanger to be coated;
d) a step of applying the suspension to the part of the exchanger to be coated;
e) a first step of heating the exchanger/suspension assembly at a temperature of between 50 °C and 300 °C and for a period of between 30 minutes and 5 hours so as to at least partly eliminate the liquid;
f) a second step of heating the exchanger/suspension assembly resulting from step e) at a temperature higher than the melting temperature of the pickling flux for a period of between 20 minutes and 6 hours so as to cause the pickling flux and the metal or alloy to be deposited to react;
g) a step of eliminating the powder residues of the pickling flux; and
h) a step of recovering an exchanger/cladding assembly;
the grinding step a) being carried out so as to obtain only particles having an equivalent diameter d such that d ≤ e_{cm}/10.

3. The method according to either claim 1 or claim 2, **characterised in that** step e) is carried out in an atmosphere renewed every x minutes with 1 min ≤ x ≤ 20 min.

4. The method according to any of claims 1 to 3, **characterised in that** step f) is carried out in a static neutral gas atmosphere, the neutral gas being for example argon.

5. The method according to any of claims 1 to 4, **characterised in that** at step b) at least one organic compound is added to the mixture.

6. The method according to claim 5, **characterised in that** the organic compound is chosen from binders, lubricants and dispersing agents.

7. The method according to either claim 5 or claim 6, **characterised in that** said method comprises, between step e) and step f), a step i) of heating the exchanger/suspension assembly resulting from step e) at a temperature of between 400 °C and the melting temperature of the least refractory element of the metal or alloy to be deposited and for a period of between 1 and 10 hours so as to eliminate or degrade the organic compounds.

8. The method according to claim 7, **characterised in that** step i) is carried out in an atmosphere renewed every x minutes with 1 min ≤ x ≤ 20 min.

9. The method according to any of claims 1 to 8, **characterised in that** the application step d) is carried out:
- by immersing the exchanger in the suspension;
- by injecting the suspension into the cavity of the exchanger; or
- by applying the suspension by brush in the cavity of the exchanger.

10. The method according to any of claims 1 to 9, **characterised in that** the step g) of eliminating the residues is carried out by vibration or washing with aqueous solutions.

11. The method according to any of claims 1 to 10, **characterised in that** said method comprises, after step h), a last step of heating the exchanger/cladding assembly at a temperature of between 900 and 1200 °C and for a period of between 1 and 5 hours.

12. The method according to any of claims 1 to 11, **characterised in that** the cladding of the exchanger/cladding assembly recovered at step h) has a thickness of between 5 µm and 200 µm preferably between 5 and 80 µm, more preferentially between 20 and 60 µm.
